# EUROPEAN PATENT APPLICATION

(11) **EP 4 213 197 A1**
(43) Date of publication of application: **19.07.2023**
(21) Application number: 22151106.6
(22) Date of filing: 12.01.2022
(51) Int. Cl.: H01L 23/14, H01L 23/498, H01L 23/13

(54) **A SEMICONDUCTOR PACKAGE SUBSTRATE MADE FROM NON-METALLIC MATERIAL AND A METHOD OF MANUFACTURING THEREOF**

(71) Applicant: Nexperia B.V., 6534 AB Nijmegen (NL)
(72) Inventor: Zhao, YuJun, Dongguan 523750 (CN); Yi, JinXin, Dongguan 523750 (CN); Li, Yuan, Dongguan 523750 (CN); Burmeister, Frank, 22529 Hamburg (DE); Tena, Edward, Dongguan 523750 (CN)
(74) Representative: Pjanovic, Ilija

(57) **Abstract**

The disclosure proposes a semiconductor package substrate (1) made from non-metallic material having a first (top) surface (6), a second (bottom) surface (7) opposite from the first surface, and at least one side surface (8), the substrate comprising at least two pads (2) positioned on the first surface (6) and suitable for receiving an electronic element (3), an encapsulant material layer (4) covering the first surface (6), at least two terminals (5) positioned on the second surface and electrically connected to the pads (2), wherein a portion of at least one of the two terminals (5) is exposed at the at least one side surface (8) and structured as a wettable flank (9).

## Description

### TECHNICAL FIELD

The present disclosure relates to a semiconductor package substrate with side wettable flank (SWF) features and a method of manufacturing thereof. In particular this disclosure relates to leadless semiconductor devices and an associated method of manufacturing such devices.

### BACKGROUND OF THE DISCLOSURE

Typical semiconductor devices comprise a semiconductor die attached to a lead metallic frame and encapsulated forming a semiconductor package. Bonding pads on the die are electrically connected to leads of the lead frame with bond wires. This assembly is encapsulated with a mould compound, which protects the die and wire bonds from environmental and physical damage. The resulting IC package can then be mounted onto a printed circuit board (PCB) and/or connected to other electrical components. The leads are non-wettable at their flanks due to the untreated copper surface that is exposed yet flush with the side walls of the device. That is, due to the manner in which the semiconductor packages are singulated with a saw blade, the surface of the exposed lead or flank is flush with the mould compound of the device such that solder does not readily climb-up or "wick" the flank of the package meaning that the QFN package is not flank wettable during reflow. This makes it difficult to inspect the solder joints after the package has been attached to a substrate or circuit board. Furthermore, this also reduces the solderable area of the leads thus reducing solder strength.

Currently most semiconductor leadless plastic packages have a non-exposed metallic lead end, sometimes termed a "pullback" lead terminal. Some end customers or users do not prefer to use this package type due to non-visibility of the solder joint after mounting on a PCB. Particularly, medical, military and automotive applications require all solder joints to be visible under low power microscope inspection, which is difficult for pullback terminals. Thus, planar terminals are often preferred (sometimes termed "no pullback" terminals).

This above mentioned structures does not enable AOI (Automatic Optical Inspection) performed by an automated camera system and image analysis configured for automatic solder joints flaws identification.

Accordingly, it is a goal of the present disclosure to provide an improved semiconductor structure and method of manufacturing thereof.

### SUMMARY OF THE DISCLOSURE

Various examples are directed to issues such as those addressed above and/or others which may become apparent from the following disclosure concerning improving automated visual inspection (AOI) of solder joints and providing for reduced device height with non-metallic lead frame.

In certain examples, aspects of the present disclosure relate to a semiconductor package substrate made from non-metallic material having a first (top) surface, a second (bottom) surface opposite from the first surface, and at least one side surface. The substrate comprising:
- at least two pads positioned on the first surface and suitable for receiving an electronic element,
- an encapsulant material layer covering the first surface,
- at least two terminals positioned on the second surface and electrically connected to the pads,
   wherein a portion of at least one of the two terminals is exposed at the at least one side surface and structured as a wettable flank.

The semiconductor package substrate may comprise the wettable flank that has a vertical groove on the side surface forming a slot hole.

In a further example of the semiconductor package substrate the slot hole may extend to the second surface.

Next, in an example, the slot hole may be formed as a U-shape groove.

The semiconductor package substrate may comprise a semiconductor package substrate that is a multilayer circuit element.

The semiconductor package substrate may comprise the semiconductor package substrate that is an organic laminated substrate, preferably a raisin based laminated substrate.

According to an embodiment there is also provided a method of manufacturing a semiconductor package substrate, the method comprising the steps of:
a. providing a substrate (DTF) having a first (top) substrate surface and a second substrate surface opposite from the first substrate surface, with the first substrate surface being pre-plated with a first metal layer having a first layer surface and a second layer surface opposite of the first layer surface, the second layer surface contacting the first substrate surface;
b. forming a plurality of first metal layer (M1) areas in the first metal layer, the plurality of first metal layer (M1) areas being separated from each other by means of exposed first substrate surface parts of the substrate;
c. forming a metallic pillar bump on the first layer surface of each of the first metal layer (M1) areas;
d. applying a prepreg layer material between the pillar bumps and the first metal layer (M1) areas and the exposed first substrate surface parts of the substrate;
e. removing the pillar bumps exposing the first layer surface of each of the first metal layer (M1) areas forming slot holes between the prepreg layer material;
f. removing the substrate material exposing the second layer surface of each of the first metal layer (M1) areas and the prepreg layer material applied in step d);
g. plating a second metal layer (M2) on the slot holes forming terminals with wettable flanks;
h. applying a solder mask layer on the exposed opposite layer surfaces sides of the prepreg layer material;
i. plating the second layer surface of each of the first metal layer (M1) areas forming pads for receiving an electronic element;
j. final plating the terminals and the wettable flanks.

Additionally, the disclosure may comprise the step of applying a protective layer on the first layer surface of each of the plurality of first metal layer (M1) areas.

The method may further comprise, after step d) but before step e), the step of grinding the prepreg layer thereby exposing the pillar bumps.

The method may use the first and second metal layers being made from copper.

The method may use the further step of removing a metal layer by chemical etching approach.

In an example, step g) may comprise the step of plating the second metal layer (M2) by means of multi-layer plating followed by the steps of coating, exposure, development, deposition seed layer removal and stripping.

According to an another embodiment there is also provided a method of manufacturing a semiconductor package substrate according to the disclosure, comprising the steps of:
a. providing a substrate (DTF) having a first (top) substrate surface and a second substrate surface opposite from the first substrate surface, with the first substrate surface being pre-plated with a first metal layer (M1) having a first layer surface and a second layer surface opposite of the first layer surface, the second layer surface contacting the first substrate surface;
b. forming a plurality of first metal layer (M1) areas in the first metal layer, the plurality of first metal layer (M1) areas being separated from each other by means of exposed first substrate surface parts of the substrate;
c. applying a prepreg layer on the exposed first surface parts of the substrate (DTF) and on the first layer surface of each of the first metal layer (M1) areas;
d. laminating a third metal layer (M3) on the prepreg layer applied in step c);
e. removing the substrate (DTF) material exposing the second layer surface of each of the first metal layer (M1) areas and the prepreg layer material applied in step c);
f. drilling holes through the third metal layer (M3) and though the prepreg layer to expose the first layer surface of each of the first metal layer (M1) areas forming slot holes (10) between the prepreg layer material;
g. plating a second metal layer (M2) on the slot holes;
h. locally removing second metal layer (M2) and the third metal layer (M3) thereby exposing prepreg layer material;
i. plating a second metal layer (M2) on the prepreg layer forming terminals with flanks;
j. applying a solder mask layer on the exposed opposite surface sides of the prepreg layer material;
k. plating the second layer surface of each of the first metal layer (M1) areas forming pads for receiving an electronic element;
   I. final plating the terminals and the wettable flanks.

The method may use the metal layers are made from copper.

The method may use the removing a metal layer by chemical etching approach.

The method may further comprise step g) comprises the step of plating the second metal layer (M2) by means of multi-layer plating followed by the steps of coating, exposure, development, deposition seed layer removal and stripping.

### BRIEF DESCRIPTION OF THE DRAWINGS

The disclosure will now be discussed with reference to the drawings, which show in:
Figure 1 a substrate strip (bottom view) and an individual package (1) on strip (dotted line; bottom view);

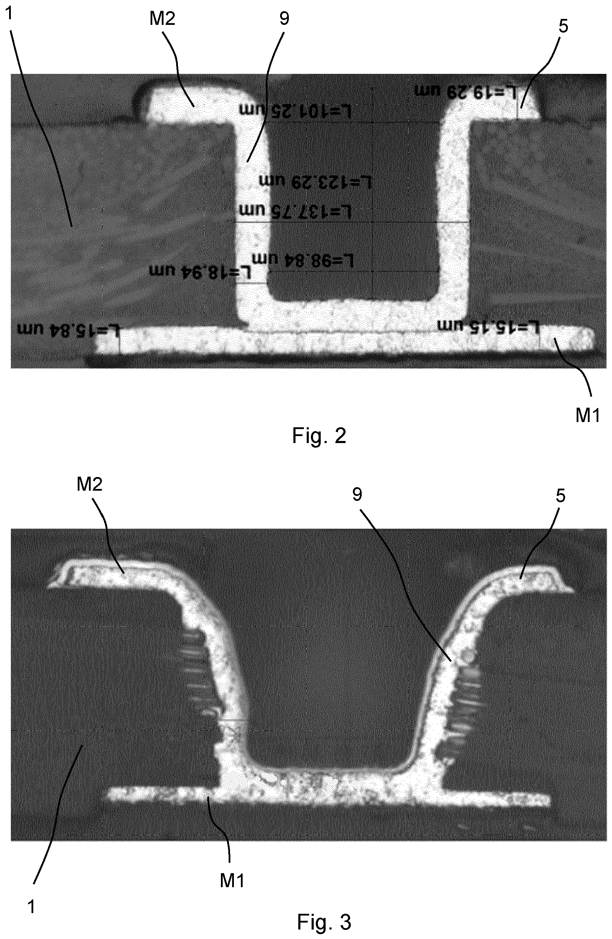

Figure 2 a wettable flank (9) cross section also referred as SWF (Side Wettable Flank) made using copper etching approach;
Figure 3 a wettable flank (9) cross section also referred as SWF (Side Wettable Flank) made using laser cutting approach;
Figure 4 a schematic view of a semiconductor package substrate with a SWF (Side Wettable Flank) and a semiconductor element mounted thereon;
Figure 5 schematically the steps of the method of manufacturing a semiconductor package substrate with a SWF using an etching based process approach;
Figure 6 shows schematically the steps of the method of manufacturing a semiconductor package substrate with a SWF using a laser drilling based process approach.

### DETAILED DESCRIPTION OF THE DISCLOSURE

For a proper understanding of the disclosure, in the detailed description below corresponding elements or parts of the disclosure will be denoted with identical reference numerals in the drawings.

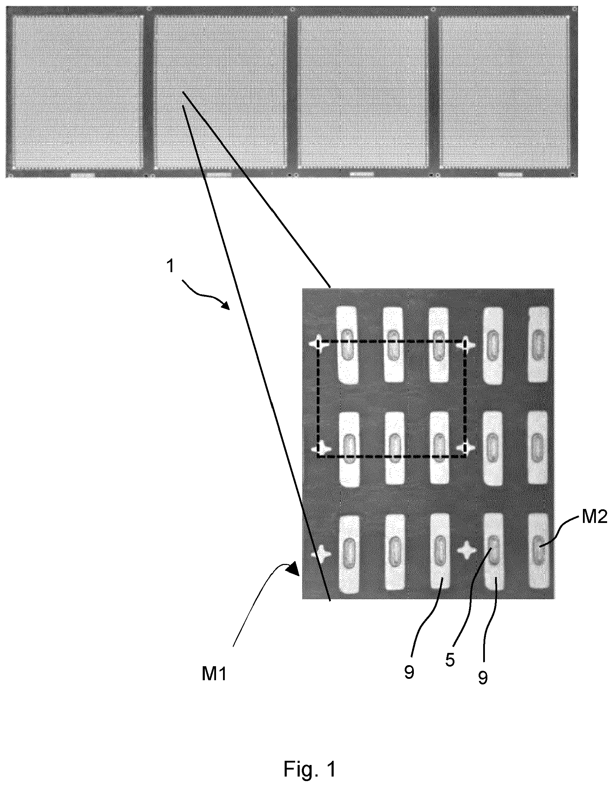

In order to realize substate based packages with very precise U-shaped and easy to solder SWFs (9) a method of manufacturing a package substrate (1)is disclosed. Using a copper pillar etching process based approach for the SWF slot (9) hole or via formation was introduced in cooperation with Substrate supplier ZhuHai ACCESS Semiconductor Co., Limited. The slot holes for the SWF features are implemented in the middle between the connected terminal pads of adjacent packages on the substrate strip (see Figure 1). The SWFs (9) are created by blade sawing process when separating the individual packages after assembly out of the substrate strip (dotted line in Figure 1).

To provide best-in-class performance for high-speed data communication applications such as automotive ethernet, ESD protection devices with ultra-low capacitance and inductance housed in packages with low parasitic characteristics are essential. In contrast to traditional lead frame based packages, packages using organic laminate substrate like Land Grid Array (LGA) packages can satisfy this key requirement and offer additional benefits such as high design diversity by internal routing capability and enhanced flexibility in form-factors and outlines.

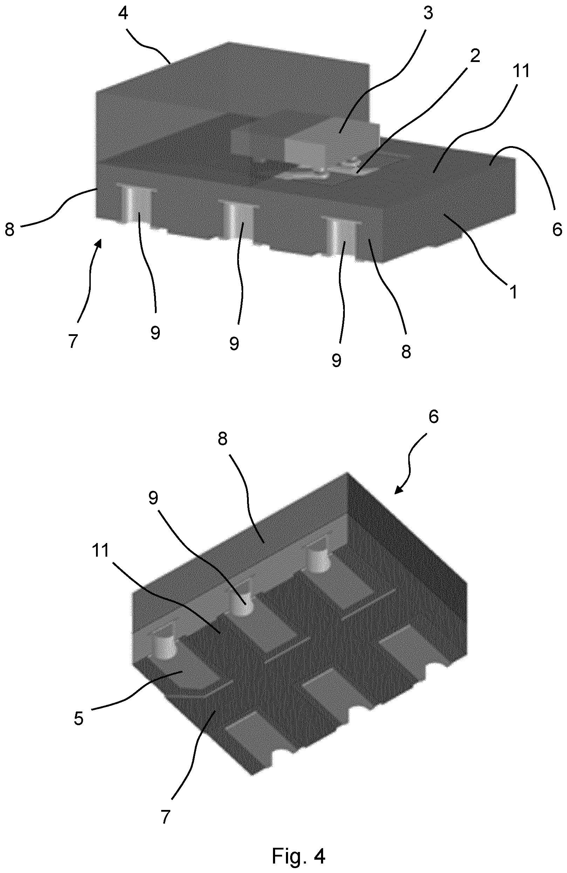

According to the disclosure, a semiconductor package substrate is proposed with SWF (9) features that enables semiconductor substrate-based packages such as shown in Figure 4 with improved board-level mechanical robustness. Such configuration allows for a 100% automatic visual inspection (AOI) under post-assembly circumstances, as required by e.g. the automotive industry.

Characteristics of the semiconductor package substrate according to the disclosure are very precise U-shaped SWF (9) slot holes which are easy to solder on the terminal (5), wherein Cu pillars are plated first, followed by laminating a Prepreg layer, and subsequent etching technique of the Cu pillar bump in order to form slot holes.

This technique allows to create substrates of a very thin dimension, being defined by a minimum SWF slot hole height, whilst having an improved board-level mechanical robustness (e.g. bending test, drop testing). The final product of the substrate-based package enables a 100% automatic visual inspection (AOI) post-assembly. In addition, this technique is suitable for all die interconnection technologies such as wire bonding, flip-chip die attachment, etc.

Furthermore, the disclosure is applicable for multi-layer substrates without and with redistribution layers (RDL) layout for an optimal die interconnection and minimum package parasitic.

More precisely the semiconductor package substrate (1) shown in the Figure 4 is made from a non-metallic material having a first (top) surface (6), a second (bottom) surface (7) opposite from the first surface, and at least one side surface (8). Nonmetallic materials can be organic materials like natural on synthetic raisins or composite materials comprising any kind of organic material suitable for making a substrate like raisins, polymers, thermoplastic polymers.

The substrate for the semiconductor device should comprise some electric connections areas for providing an electric connection of package terminals (5) with the silicon semiconductor element. An example of such element is a transistor device having a source connector, a drain connector and a gate connector. Such element would require a semiconductor package substrate having three pads, denoted with reference numeral 2.

In another example, an diode element could be attached to the semiconductor package substrate (1), this kind of element would require two pads (2) for making it operatively connected.

In a further example, the semiconductor package substrate comprises at least two pads (2) positioned on the first surface (6) and are suitable for receiving an electronic element (3) (such as a transistor, or a diode or any other electronic element). Additionally, an encapsulant material layer (4) is covering the first surface (6).

The at least two terminals (5) are positioned on the second surface (7) and are electrically connected to the pads (2). Not every terminals (5) need to be connected to the electronic element (3). A portion of at least one of the two terminals (5) is exposed at the at least one side surface (8) and structured as a wettable flank (9). This exposure is needed for preforming a soldering operation to an printed circuit board (not shown in figures). Hot soldering is performed with melted metal alloy which forms an electric connection by wetting the exposed terminals (5) and then freezing is performed forming a mechanical and electric connection between a printed circuit board and the semiconductor package pad (5) and the flank (9).

For forming a more reliable connection, more alloy is to be applied (to stick) to the terminal (5) and wettable flank (9). In some examples of the semiconductor package the wettable flank (9) may have a vertical groove (12) on the side surface (8) forming a slot hole (10). This provides more space for soldering alloy to stick to the terminal (5). In some examples solder alloy is required to fill the space under the semiconductor package therefore the semiconductor package may have the slot hole (10) to extend further towards the second surface (7).

For the reasons mentioned above the wettable flank (9) may have additional grooves and accordingly the slot hole (10) can be formed as a U-shape groove.

In a preferred example the electronic element (3) is a complex structure with multiple connection areas. Therefore the substrate (1) also require multiple connection pads (2). To provide such complex pads (2) the substrate (1) is patterned as a multilayer circuit element. This multilayer circuit element may comprise many layers of organic material layers and many layers of conductive material layers, wherein the conductive material layers form a specific pattern and may comprise multiple connections through the organic material layers.

In such example the substrate (1) forms a multilayer printed circuit board by itself.

The semiconductor package substrate (1) of the semiconductor package can be formed as an organic laminated substrate, preferably a resin based laminated substrate.

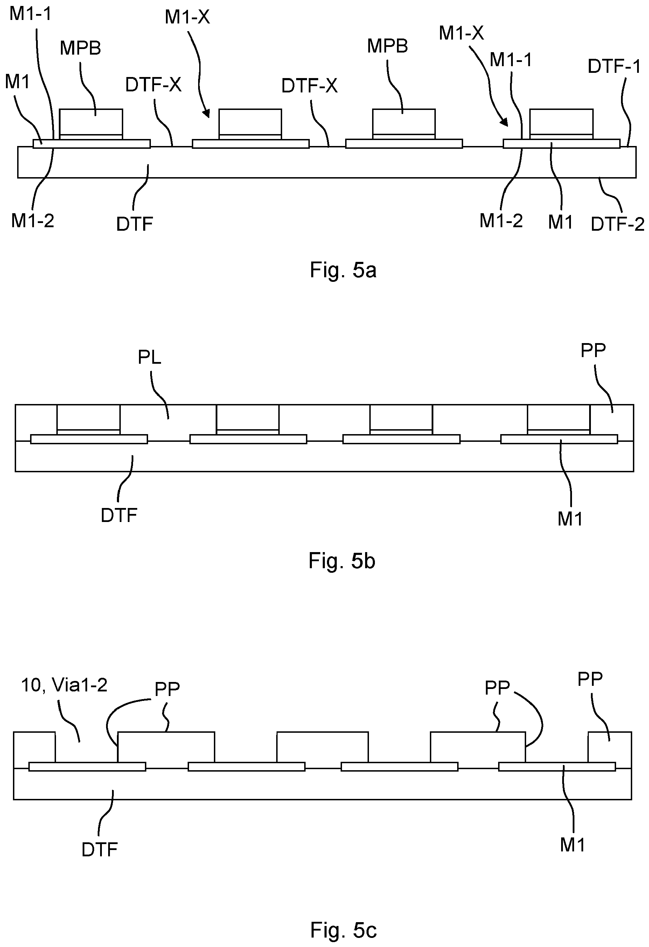

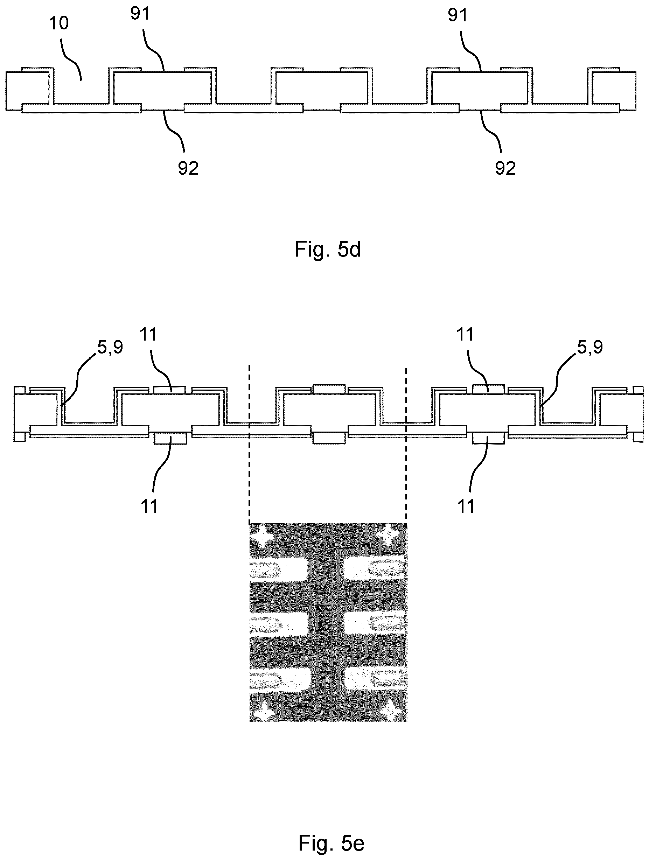

A method of manufacturing a semiconductor package substrate according to the disclosure uses technologies which are known in the printed circuit board processes as shown in Figure 5. The method may comprise the steps of:
a. in Figure 5a, providing a substrate (DTF) having a first (top) substrate surface (DTF-1) and a second substrate surface (DTF-2) opposite from the first (top) substrate surface (DTF-1), with the first substrate surface (DTF-1) being pre-plated with a first metal (M1) layer having a first layer surface (M1-1) and a second layer surface (M1-2) opposite of the first layer surface, the second layer surface (M1-2) contacting the first substrate surface (DTF-1).
b. in Figure 5a, forming a plurality of first metal layer (M1) areas (M1-x) in the first metal layer (M1), the plurality of first metal layer (M1) areas (M1-x) being separated from each other by means of exposed first substrate surface parts (DTF1-x) of the substrate (DTF);
c. in Figure 5a, forming a metallic pillar bump (MPB) on the first layer surface (M1-1) of each of the first metal layer (M1) areas (M1-x), wherein the metallic pillar bump (MPB) is formed by plating a metal e.g. Cu in the Via (1-2) area. Between the metallic pillar bump (MPB) and the first metal layer (M1) areas (M1-x) a protective layer (PL) may be deposited, see Figure 5b. Although this deposition of the protective layer (PL) provides an easier etching of the metallic pillar bump (MPB), it should be note that this step is optional and might not be needed.
d. in Figure 5b, the step of applying a prepreg layer (PP) material between the pillar bumps (MPB) and the first metal layer (M1) areas (M1-x) and the exposed first substrate surface parts (DTF-x) of the substrate (DTF);
e. in Figure 5c, removing the pillar bumps (MPB) exposing the first layer surface (M1-1) of each of the first metal layer (M1) areas (M1-x) forming slot holes (10) between the prepreg layer (PP) material;
f. in Figure 5d, removing the substrate material (DTF, DTF Carrier) exposing the second layer surface (92) of each of the first metal layer (M1) areas and the prepreg layer (PP) material (91) applied in step d);
g. in Figure 5e, plating a second metal layer (M2) on the slot holes (10) forming terminals (5) with wettable flanks (9);
h. in Figure 5e, applying a solder mask layer (11) on the exposed opposite layer surfaces sides (91, 92) of the prepreg layer material (PP);
i. plating the second layer surface of each of the first metal layer (M1) areas forming pads (2) for receiving an electronic element (3);
j. final plating the terminals (5) and the wettable flanks (9).

According to the disclosure, as an additional step after step b) but before step c) there is a step of applying a protective layer (PL) on the first layer surface (M1-1) of each of the plurality of first metal layer (M1) areas.

Furthermore, after step d) but before step e) a step of grinding the prepreg layer (PP) can be performed, thereby exposing the pillar bumps (MPB).

Preferably, the first and second metal layers are made from copper.

Furthermore, the step of removing a metal layer can be performed by chemical etching.

Preferably in a further example of the disclosure, the step g) comprises the step of plating the second metal layer (M2) by means of multi-layer plating followed by the steps of coating, exposure, development, deposition seed layer removal and stripping.

Additionally, the formed slot holes 10 may be filled with a conductive solderable material (not shown), which is cured after filling. Next, the surface is grinded. After grinding, a Cu layer can be electroplated. A masking layer is arranged over the electroplated Cu layer. This masking layer is patterned, e.g. using lithography techniques, thereby creating openings in the masking layer. Next, the electroplated Cu layer is etched through the created openings and the masking layer is removed. Then, a solder mask is applied and patterned. The part of the electroplated Cu layer that is exposed after patterning the solder mask is subjected to an electroless plating process, such an electroless nickel electroless palladium immersion gold plating (ENEPIG) process, resulting in the formation of an ENEPIG PCB.

The resulting ENEPIG PCB, is a type of metal plated PCB, denoted as Electroless Nickel - Electroless Palladium - Immersion Gold, which is a surface finish for PCBs. It commonly referred as "universal surface finish" for its ability to be deposited on just about any prototype PCB assembly, and ENEPIG finishes are primarily used to support soldering and gold and aluminum wire bonding. On top of these functionalities, ENEPIG plating also extends the functional shelf life of a plated PCB well beyond a year.

ENEPIG involves four layers of metal deposited on a PCB surface. These materials can be copper, nickel, palladium and gold. The process of creating an ENEPIG surface finish includes the following steps:

The step of Copper Activation: In this step, the copper layer that needs protection is selectively activated, the latter determining the deposition pattern in the electroless nickel plating step. This process is accomplished using a displacement reaction, which makes the copper layer act as a catalytic surface.

The step of Electroless Nickel: Nickel acts as a barrier layer, preventing copper from interacting with the other metals involved in this plating technology, particularly gold. The layer is deposited on the catalytic copper surface using an oxidation-reduction reaction. The result is a layer that is between 3.0 to 5.0 microns thick.

The step of Electroless Palladium: The layer of palladium is what differentiates ENEPIG from an ENEG surface finish technology, acting as another barrier layer. Palladium prevents the nickel layer from corroding and diffusing into the gold layer. It also acts as an anti-oxidation and anti-corrosion layer. Like nickel, this layer is deposited using an electroless reaction, which uses a chemical oxidation-reduction reaction to cause the nickel surface to react with palladium and form a thin layer. This palladium is deposited on a layer with a thickness of 0.05 to 0.1 microns, depending on the application.

The step of Immersion Gold: Gold is the final layer added to ENEPIG surfaces, lending the benefits of low contact resistance, protection from friction and resistance to oxidation. Gold also preserves palladium's solderability. As the name suggests, immersion gold plating services completely immerse the covered PCB, using a displacement reaction where palladium on the PCB dissolves and releases electrons that reduce the gold atoms surrounding it. The gold ions then attach to the surface of the PCB, replacing some palladium ions and resulting in a relatively thin outer layer, between 0.03 and 0.05 microns thick - substantially lower than any other solution.

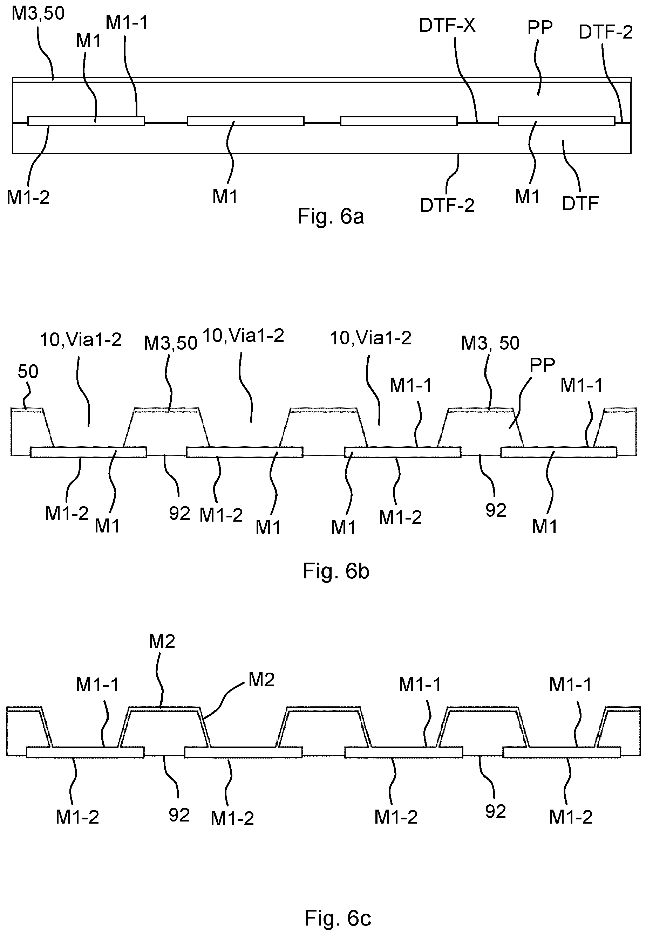

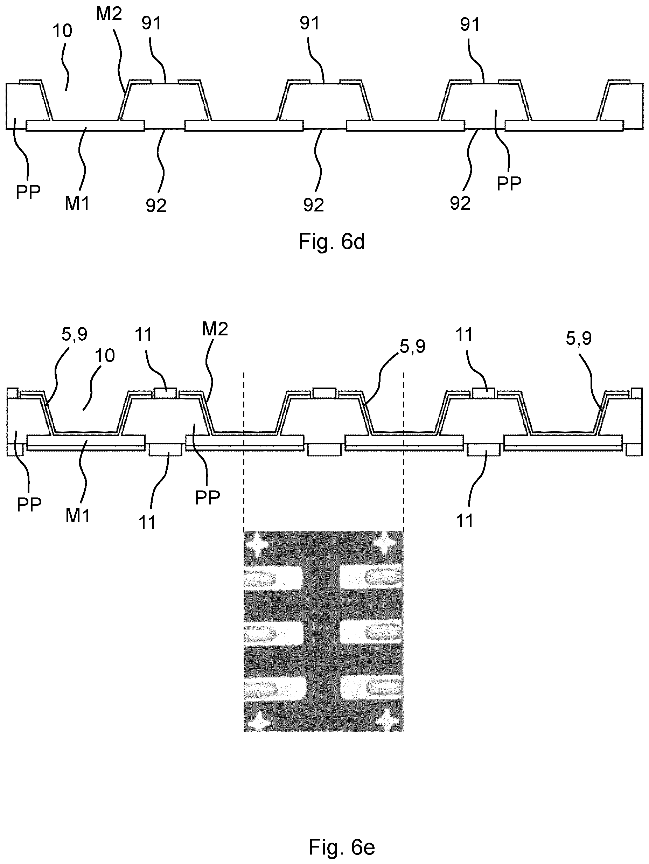

An alternative method of manufacturing a semiconductor package substrate according to the disclosure is shown in Figure 6 and comprising the steps of:
a. see Figure 6a, providing a substrate (DTF) having a first (top) substrate surface (DTF-1) and a second substrate surface (DTF-2) opposite from the first substrate surface (DTF-1), with the first substrate surface (DTF-1) being pre-plated with a first metal layer (M1) having a first layer surface (M1-1) and a second layer surface (M1-2) opposite of the first layer surface (M1-1), the second layer surface (M1-2) contacting the first substrate surface ((DTF-1);
b. see Figure 6a, forming a plurality of first metal layer areas (M1-x) in the first metal layer (M1), the plurality of first metal layer (M1) areas being separated from each other by means of exposed first substrate surface parts (DFT-x) of the substrate (DTF);
c. see Figure 6a, applying a prepreg layer (PP) on the exposed first surface parts (DFT-x) of the substrate (DTF) and on the first layer surface (M1-1) of each of the first metal layer (M1) areas;
d. see Figure 6a, laminating a third metal layer (M3, 50) on the prepreg layer (PP) as applied in step c);
e. see Figure 6b, removing the substrate (DTF) material exposing the second layer surface (M1-2) of each of the first metal layer (M1) areas and the prepreg layer material (PP, q2) applied in step c);
f. see Figure 6b, drilling holes (10, Via 1-2) through the third metal layer (M3) and though the prepreg layer (PP) to expose the first layer surface of each of the first metal layer (M1) areas forming slot holes (10) between the prepreg layer (PP) material;
g. see Figure 6c, plating a second metal layer (M2) on the slot holes (10);
h. see Figure 6d, locally (denoted with q1) removing second metal layer (M2) and the third metal layer (M3) thereby exposing prepreg layer (PP) material;
i. see Figure 6e, plating a second metal layer (M2) on the prepreg layer forming terminals (5) with flanks (9);
j. see Figure 6e, applying a solder mask layer (11) on the exposed opposite surface sides (q1, q2) of the prepreg layer (PP) material;
k. plating the second layer surface of each of the first metal layer (M1) areas forming pads (2) for receiving an electronic element (3);
   I. final plating the terminals (5) and the wettable flanks (9).

In the method the metal layers (M1, M2, M3, 50) can be made from copper.

In an example of the method according to the disclosure, the removal of any of the metal layers can be performed by chemical etching.

Additionally, step g) may comprise the step of plating the second metal layer (M2) by means of multi-layer plating followed by the steps of coating, exposure, development, deposition seed layer removal and stripping.

The technique of the disclosure can be applied to all kind of semiconductor products, especially for those requiring excellent RF- performance, high board-level robustness and automatic visual inspection (AOI) capability post-assembly for automotive applications. The range of possible products cover, among others, ESD protection devices for high-speed data communication applications such as automotive Ethernet and Gallium Nitrid (GaN) FETs for high speed switching.

The use of the disclosure could be detected on semiconductor package level by the very precise U-shape of the SWFs (9) with straight side walls. This unique U-shape is the key differentiator to V-shape like SWFs created by a laser drilling based process approach.

The disclosure could be adapted to realize embedded packages with U-shape like SWFs. Furthermore, it might be possible to adapt the disclosure by forming the Cu-pillar by photomask patterning and etching out of a thick Cu substrate with Metal M1 plating rather than plating a Cu-pillar bump on a carrier with Metal M1 plating.

## Claims

1. A semiconductor package substrate (1) made from non-metallic material having a first (top) surface (6), a second (bottom) surface (7) opposite from the first surface, and at least one side surface (8), the substrate comprising
- at least two pads (2) positioned on the first surface (6) and suitable for receiving an electronic element (3),
- an encapsulant material layer (4) covering the first surface (6),
- at least two terminals (5) positioned on the second surface and electrically connected to the pads (2),
wherein a portion of at least one of the two terminals (5) is exposed at the at least one side surface (8) and structured as a wettable flank (9).

2. The semiconductor package substrate according to claim 1, wherein the wettable flank (9) has a vertical groove (12) on the side surface (8) forming a slot hole (10).

3. The semiconductor package substrate according to claim 2, wherein the slot hole (10) extends to the second surface (7).

4. The semiconductor package substrate according to any one or more of the claims 1-3, wherein the slot hole (10) is formed as a U-shape groove.

5. The semiconductor package substrate according to any one or more of the claims 1-4, wherein semiconductor package substrate (1) is a multilayer circuit element.

6. The semiconductor package substrate according to any one or more of the claims 1-5, wherein the semiconductor package substrate (1) is an organic laminated substrate, preferably a raisin based laminated substrate.

7. A method of manufacturing a semiconductor package substrate as defined in any one or more of the claims 1-6, the method comprising the steps of:
a. providing a substrate (DTF) having a first (top) substrate surface and a second substrate surface opposite from the first substrate surface, with the first substrate surface being pre-plated with a first metal layer having a first layer surface and a second layer surface opposite of the first layer surface, the second layer surface contacting the first substrate surface;
b. forming a plurality of first metal layer (M1) areas in the first metal layer, the plurality of first metal layer (M1) areas being separated from each other by means of exposed first substrate surface parts of the substrate;
c. forming a metallic pillar bump (MPB) on the first (top) layer surface of each of the first metal layer (M1) areas;
d. applying a prepreg layer (PP) material between the pillar bumps (MPB) and the first metal layer (M1) areas and the exposed first substrate surface parts of the substrate;
e. removing the pillar bumps (MPB) exposing the first layer surface of each of the first metal layer (M1) areas forming slot holes between the prepreg layer (PP) material;
f. removing the substrate material exposing the second layer surface of each of the first metal layer (M1) areas and the prepreg layer (PP) material applied in step d);
g. plating a second metal layer (M2) on the slot holes (10) forming terminals (5) with wettable flanks (9);
h. applying a solder mask layer (11) on the exposed opposite layer surfaces sides of the prepreg layer material;
i. plating the second layer surface of each of the first metal layer (M1) areas forming pads (2) for receiving an electronic element (3);
j. final plating the terminals (5) and the wettable flanks (9).

8. The method according to claim 7, wherein, after step b) but before step c) the method further comprising the step of applying a protective layer (PL) on the first layer surface of each of the plurality of first metal layer (M1) areas.

9. The method according to claim 7 of 8, wherein, after step d) but before step e) the method further comprising the step of grinding the prepreg layer thereby exposing the pillar bumps (MPB).

10. The method according to any one or more of the claims 7-9, wherein the first and second metal layers are made from copper.

11. The method according to claim 7 or 8, wherein removing a metal layer is performed by chemical etching.

12. The method according to any one or more of the claims 7-11, wherein the step g) comprises the step of plating the second metal layer (M2) by means of multi-layer plating followed by the steps of coating, exposure, development, deposition seed layer removal and stripping.

13. A method of manufacturing a semiconductor package substrate as defined in any one or more of the claims 1-6, the method comprising the steps of:
a. providing a substrate (DTF) having a first (top) substrate surface and a second substrate surface opposite from the first substrate surface, with the first substrate surface being pre-plated with a first metal layer (M1) having a first layer surface and a second layer surface opposite of the first layer surface, the second layer surface contacting the first substrate surface;
b. forming a plurality of first metal layer (M1) areas in the first metal layer, the plurality of first metal layer (M1) areas being separated from each other by means of exposed first substrate surface parts of the substrate;
c. applying a prepreg layer (PP) on the exposed first (top) surface parts of the substrate (DTF) and on the first layer surface of each of the first metal layer (M1) areas;
d. laminating a third metal layer (M3) on the prepreg layer (PP) applied in step c);
e. removing the substrate (DTF) material exposing the second layer surface of each of the first metal layer (M1) areas and the prepreg layer (PP) material applied in step c);
f. drilling holes through the third metal layer (M3) and though the prepreg layer (PP) to expose the first layer surface of each of the first metal layer (M1) areas forming slot holes (10) between the prepreg layer (PP) material;
g. plating a second metal layer (M2) on the slot holes (10);
h. locally removing second metal layer (M2) and/or the third metal layer (M3) thereby exposing prepreg layer (PP) material;
i. plating a second metal layer (M2) on the prepreg layer (PP) forming terminals (5) with flanks (9);
j. applying a solder mask layer (11) on the exposed opposite surface sides of the prepreg layer (PP) material;
k. plating the second layer surface of each of the first metal layer (M1) areas forming pads (2) for receiving an electronic element (3);
l. final plating the terminals (5) and the wettable flanks (9).

14. The method according to claim 13, wherein removing a metal layer is performed by chemical etching.

15. The method according to any one or more of the claims 13 or 14, wherein the step g) comprises the step of plating the second metal layer (M2) by means of multi-layer plating followed by the steps of coating, exposure, development, deposition seed layer removal and stripping.
